# EUROPEAN PATENT SPECIFICATION

(11) **EP 1 591 563 B1**
(45) Date of publication and mention of the grant of the patent: **04.04.2018**
(21) Application number: 04704363.3
(22) Date of filing: 22.01.2004
(51) Int. Cl.: C25D 3/60, C25D 3/32

(54) **TIN-CONTAINING PLATING BATH**
ZINNHALTIGES METALLABSCHEIDUNGSBAD
BAIN ELECTROLYTIQUE A BASE D'ETAIN

(30) Priority: 24.01.2003 JP 2003015562; 26.12.2003 JP 2003432338
(43) Date of publication of application: 02.11.2005
(73) Proprietor: Ishihara Chemical Co., Ltd., Kobe-shi Hyogo 652-0806 (JP); Daiwa Fine Chemicals Co., Ltd., Akashi-shi, Hyogo 674-0093 (JP); MITSUBISHI MATERIALS CORPORATION, Chiyoda-ku, Tokyo 100-8117 (JP)
(72) Inventor: MASUDA, Akihiro, Sanda Plant of MITSUBISHI MATERIALS CORPORATION, Sanda-shi, Hyogo 669-1339 (JP); KOHINATA, Masayoshi, Sanda Plant of MITSUBISHI MATERIALS CORPORATION, Sanda-shi, Hyogo 669-1339 (JP); OBATA, Keigo, DAIWA FINE CHEMICALS CO., LTD., Akashi-shi, Hyogo 674-0093 (JP); YOSHIMOTO, Masakazu, DAIWA FINE CHEMICALS CO.,LTD., Akashi-shi, Hyogo 674-0093 (JP); TSUJI, Kiyotaka, ISHIHARA CHEMICAL CO., LTD., Kobe-shi, Hyogo 652-0806 (JP); UCHIDA, Ei, ISHIHARA CHEMICAL CO., LTD., Kobe-shi, Hyogo 652-0806 (JP); ORI, Keiji, ISHIHARA CHEMICAL CO., LTD., Kobe-shi, Hyogo 652-0806 (JP); EIKAWA, Masahiro, ISHIHARA CHEMICAL CO., LTD., Kobe-shi, Hyogo 652-0806 (JP)
(74) Representative: Müller-Boré & Partner Patentanwälte PartG mbB
(86) International application number: PCT/JP2004/000524
(87) International publication number: WO 2004/065663

(56) References cited:
- EP-A1- 0 854 136
- EP-A1- 1 167 582
- EP-A2- 1 138 805
- WO-A1-00/31027
- JP-A- 8 064 601
- US-A- 4 871 429

## Description

The present invention relates to a tin or tin alloy plating bath containing an aliphatic sulfonic acid as a base acid.

Tin or tin alloy plating baths containing an organic sulfonic acid as a base acid are widely used because of easy wastewater disposal and high solubility of tin salts. Examples of organic sulfonic acids usable as such base acids include methanesulfonic acid, ethanesulfonic acid, propanesulfonic acid and like alkanesulfonic acids; 2-hydroxyethanesulfonic acid, 2-hydroxypropanesulfonic acid and like alkanolsulfonic acids; and p-phenolsulfonic acid and like aromatic sulfonic acids.

In tin or tin alloy plating baths containing such an organic sulfonic acid, in particular, a commonly used alkanesulfonic acid or like aliphatic sulfonic acid, as a base acid, there is correlation between the purity of the aliphatic sulfonic acid and the properties of the obtained plating film, and concerns have been raised that even minute amounts of impurities contained in low-purity aliphatic sulfonic acids may adversely affect the properties of the plating film.

Japanese Unexamined Patent Publication No. 204252/1998 points out that in a process comprising oxidizing an alkyl mercaptan with hydrogen peroxide, reaction intermediate residues such as disulfide contaminate the product (see paragraph 5). This publication discloses that a high-purity alkanesulfonic acid or alkanolsulfonic acid can be produced in high yield and low cost by reacting an alkyl mercaptan such as methyl mercaptan, ethyl mercaptan or 2-mercaptoethanol with hydrogen peroxide by a process comprising the following steps: feeding an aqueous solution of at least 50 wt.% hydrogen peroxide in an excess of the stoichiometrically required amount into a reaction vessel; continuously supplying thereto an alkyl mercaptan at a temperature as low as or lower than 50°C; allowing the reaction mixture to mature for about 3 to 20 hours; subjecting the reaction mixture to distillation at boiling under atmospheric pressure; and bringing the reaction mixture into contact with an anion exchanger (see the claims and paragraphs 9 to 11 of the publication). This method produces a high-purity alkanesulfonic acid by reacting an alkyl mercaptan with hydrogen peroxide, the method using peroxide in an excess of the stoichiometrically required amount, controlling the reaction temperature to a low temperature, comprising a maturing period, and further using a combination of complicated treatments such as distillation at atmospheric pressure and anion exchange treatment. The publication shows that the obtained high-purity alkanesulfonic acid can be esterified with (meth)acrylic acid and used as a reactive emulsifier. The publication further discloses that homopolymers of an alkanesulfonic acid or copolymers of an alkanesulfonic acid with a vinyl monomer can be used as flocculants, dispersants, thickeners and the like for various purposes, and are also useful as additives for tin plating baths, solder plating baths, etc. (see paragraph 2 of the publication).

Japanese Unexamined Patent Publication No. 2001-64249 describes oxidation of thiol (alkyl mercaptan), hydrolysis of halogenated alkyl sulfonyl, and oxidation of dimethyl disulfide as conventional methods for producing alkanesulfonic acids (see paragraph 3). The publication discloses a purification method comprising bringing an aqueous solution of an alkanesulfonic acid obtained by such a conventional method into contact with a basic anion exchange resin to mainly reduce the sulfuric acid content of the alkanesulfonic acid. The publication describes that although alkanesulfonic acids, particularly methansulfonic acid, are useful for plating electrically conductive metals, sulfuric acid contained as an impurity adversely affects such plating. The publication then states that the sulfuric acid content of alkanesulfonic acid can be greatly reduced by bringing the alkanesulfonic acid into contact with a basic anion exchange resin (see paragraphs 2 to 5 of the publication). EP 1 138 805 A2 describes electrolyte compositions for depositing tin or tin alloys at various current densities and methods of plating such tin or tin alloys on substrates. EP 1 167 582 A1 describes electroplating compositions for use in tin and tin alloy plating formulations. WO 00/31027 A1 describes a method of producing alkane sulfonic acid. US 4,871,429 A describes limiting the tin sludge formation in tin or tin/lead electroplating solutions. EP 0 854 136 A1 describes a process for the production of pure alkanesulfonic acids.

The present invention was made in view of the above state of the prior art. A primary object of the invention is to provide a tin or tin alloy plating bath capable of forming a plating film with excellent properties by further considering the correlation between the purity of an aliphatic sulfonic acid contained as a base acid in a tin or tin alloy plating bath and the properties of the obtained plating film.

To achieve the above object, the inventors of the present invention conducted extensive research and found that although aliphatic sulfonic acids such as alkanesulfonic acids contain, as impurities, various sulfur-containing compounds depending on the production method, only specific components such as α-chlorodimethylsulfone and dimethyldisulfide among such sulfur-containing compounds adversely affect the plating properties, and sulfur-containing compounds other than these specific components, such as dimethylsulfone, do not affect the plating properties. The inventors further found that by subjecting a commercially available alkanesulfonic acid to a specific purification/separation process such as concentration under reduced pressure, specific sulfur-containing compounds that adversely affect the plating properties can be effectively removed; and when the resulting purified alkanesulfonic acid is used not as an additive but as a base acid in a tin or tin alloy plating bath, the plating film has greatly improved reflowability, appearance, etc.; and thereby accomplished the present invention.

The present invention provides the following tin-containing plating baths:
1. A tin-containing plating bath comprising:
   (a) a soluble stannous salt, or
      a mixture of a soluble stannous salt and at least one soluble salt selected from the group consisting of copper salts, bismuth salts, silver salts, indium salts, zinc salts, nickel salts, cobalt salts and antimony salts; and
   (b) at least one purified aliphatic sulfonic acid selected from the group consisting of alkanesulfonic acids and alkanolsulfonic acids,
      wherein the purified aliphatic sulfonic acid is one obtained by purifying an aliphatic sulfonic acid that has been produced by hydrolyzing an alkylsulfonyl halide, the content of α-chlorodimethylsulfone in the plating path is less than 4 ppm, and the content of α-methylsulfonyl-α,α-dichlorodimethylsulfone in the plating bath is less than 4 ppm.
2. The tin-containing plating bath according to item 1 wherein at least two sulfur-containing compounds selected from the group consisting of dimethyldisulfide, S-methyl methanethiosulfonate, α-chlorodimethylsulfone and α-methylsulfonyl-α,α-dichlorodimethylsulfone are present in the plating bath; and
   the total content of the sulfur-containing compounds in the plating bath is less than 2 ppm.
3. The tin-containing plating bath according to item 1 wherein the purified aliphatic sulfonic acid is one obtained by subjecting an aliphatic sulfonic acid to concentration under reduced pressure while heating.
4. The tin-containing plating bath according to item 1 wherein the purified aliphatic sulfonic acid is one obtained by subjecting an aliphatic sulfonic acid to solid phase extraction in which the aliphatic sulfonic acid is brought into contact with an adsorbent.
5. The tin-containing plating bath according to item 4 wherein the purified aliphatic sulfonic acid is one obtained by subjecting an aliphatic sulfonic acid to solid phase extraction at least twice, using the same or different kinds of adsorbents.
6. The tin-containing plating bath according to item 1 wherein the purified aliphatic sulfonic acid is one obtained by subjecting an aliphatic sulfonic acid to a combination of concentration under reduced pressure and solid phase extraction.
7. The tin-containing plating bath according to item 1 wherein the alkanesulfonic acid is methanesulfonic acid.

The tin-containing plating bath of the invention contains as a plating metal component a soluble stannous salt alone, or a soluble stannous salt together with at least one soluble salt selected from the group consisting of copper salts, bismuth salts, silver salts, indium salts, zinc salts, nickel salts, cobalt salts and antimony salts, and contains as a base acid at least one aliphatic sulfonic acid selected from the group consisting of alkanesulfonic acids and alkanolsulfonic acids.

Among aliphatic sulfonic acids usable as base acids, examples of usable alkanesulfonic acid are those represented by the formula CₙH₂ₙ₊₁SO₃H (for example, n is 1 to 11) . Specific examples of such alkanesulfonic acids include methansulfonic acid, ethanesulfonic acid, 1-propanesulfonic acid, 2-propanesulfonic acid, 1-butanesulfonic acid, 2-butanesulfonic acid, pentanesulfonic acid and the like.

Examples of usable alkanolsulfonic acid are those represented by the formula CₘH₂ₘ₊₁-CH(OH) -CₚH₂ₚ-SO₃H (for example, m is 0 to 6 and p is 1 to 5). Specific examples of such alkanolsulfonic acids include 2-hydroxyethane-1-sulfonic acid (isethionic acid), 2-hydroxypropane-1-sulfonic acid (2-propanolsulfonic acid), 2-hydroxybutane-1-sulfonic acid, 2-hydroxypentane-1-sulfonic acid, 1-hydroxypropane-2-sulfonic acid, 3-hydroxypropane-1-sulfonic acid, 4-hydroxybutane-1-sulfonic acid, 2-hydroxyhexane-1-sulfonic acid and the like. A representative example of such alkanolsulfonic acids is 2-hydroxyethane-1-sulfonic acid.

Such alkanesulfonic acids and alkanolsulfonic acids can be used singly or mixture of two or more kinds. Among these, alkanesulfonic acids are preferable and methanesulfonic acid is particularly preferable.

A known method for producing an aliphatic carboxylic acid for use as the base acid, and in particular, an alkanesulfonic acid, comprises subjecting an alkyl mercaptan to wet oxidation (for example, an oxidation method using chlorine and water, or hydrogen peroxide). However, according to this method, dimethyldisulfide may be generated in the intermediate reaction stage. The above-mentioned Japanese Unexamined Patent Publication No. 204252/1998 also mentions the presence of reaction intermediate residues such as disulfides (see paragraph 5 of the publication). In a process of subjecting a dialkyldisulfide to wet oxidation, unreacted dialkyldisulfide may remain in the product. For example, when dimethyldisulfide is subjected to wet oxidation, a minute amount of unreacted dimethyldisulfide may remain in the product methane sulfonic acid. In a process of hydrolyzing an alkylsulfonyl halide, the product aliphatic sulfonic acid may contain minute amounts of various halogen- and sulfur-containing compounds as impurities. Wet oxidation of alkyl mercaptan using chlorine and water is also likely to have similar problems.

As shown above, aliphatic sulfonic acids may contain various sulfur-containing compounds depending on the production method.

The present inventors extracted with dichloromethane impurities contained in an unpurified aliphatic sulfonic acid and subjected the obtained mixture of impurities to liquid chromatography to identify the isolates using various analytical instruments. Subsequently, the inventors added minute amounts of these isolates to a newly purified aliphatic sulfonic acid and prepared tin or tin alloy plating baths containing as a base acid an aliphatic sulfonic acid containing these isolates as impurities to investigate the properties of the obtained plating films. As a result, the inventors drew the following noteworthy conclusion: among sulfur-containing compounds contained as impurities, while some components adversely affect the plating properties, others have no such adverse effects. The inventors identified the two groups of components that are different in their influence on plating properties and found that the components that have adverse effects have a common feature. More specifically, the inventors found that among sulfur-containing compounds contained as impurities, compounds (A) having a sulfur atom(s) with an oxidation number of +4 or less in the molecule and compounds (B) having a sulfur atom(s) and a chlorine atom(s) in the molecule in particular adversely affect the properties of the plating films obtained from tin or tin alloy plating baths.

Therefore, in the present invention, it is necessary to use as a base acid an aliphatic sulfonic acid purified in such a manner that the total content of compound(s) (A) having a sulfur atom(s) with an oxidation number of +4 or less in the molecule and compound(s) (B) having a sulfur atom(s) and a chlorine atom(s) in the molecule is zero or minute. It is preferable that the total content of the above compounds (A) and (B) in the purified aliphatic sulfonic acid be less than 200 ppm, calculated as the concentration in the plating bath.

By using a purified aliphatic sulfonic acid with such an extremely low content of specific impurities, the obtained tin or tin alloy plating film has excellent properties, particularly in terms of reflowability and film appearance.

The above-mentioned "compound(s) (A) having a sulfur atom(s) with an oxidation number of +4 or less in the molecule" specifically means compound(s) having sulfur atom(s) other than in its maximum oxidation state, i.e., sulfur atoms not having a complete octet structure. Specific examples of such sulfur-containing compounds include compound (1) represented by the following formula (a) and compound (2) represented by the following formula (b).
(1) Dimethyl disulfide

   CH₃-S-S-CH₃ (a)
(2) S-methyl methanethiosulfonate 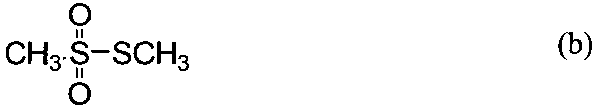
   Specific examples of compound(s) (B) having a sulfur atom(s) and a chlorine atom(s) in the molecule include compound (3) represented by the following formula (c) and compound (4) represented by the following formula (d).
(3) α-chlorodimethylsulfone 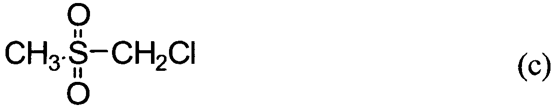
(4) α-methylsulfonyl-α,α-dichlorodimethylsulfone

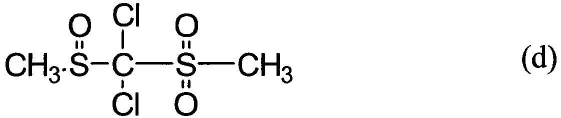

Aliphatic sulfonic acids may contain not only the above-mentioned impurities but also compounds having a sulfur atom(s) in its maximum oxidation state, such as dimethylsulfone. However, such compounds do not adversely affect the plating properties. Furthermore, aliphatic sulfonic acids may contain various other kinds of impurities depending on the production method. Therefore, it is not easily predictable that properties of plating films can be greatly improved by focusing attention only on compound(s) (A) having a sulfur atom(s) with an oxidation number of +4 or less in the molecule and compound(s) (B) having a sulfur atom(s) and a chlorine atom(s) in the molecule among the various impurities that might be present and reducing the content of compounds (A) and (B).

Most preferably, in the aliphatic sulfonic acid, the content of the impurities consisting of compound(s) (A) having a sulfur atom(s) with an oxidation number of +4 or less in the molecule and compound(s) (B) having a sulfur atom(s) and a chlorine atom(s) in the molecule is zero, i.e., unmeasurable using various analytical instruments. The compounds may be contained in minute amounts so long as they do not adversely affect tin or tin alloy plating properties, in particular, reflowability and appearance of the plating film. The permissible content varies depending on the kind of impurity. Among the above-mentioned compounds, α-chlorodimethylsulfone has the strongest adverse effects on plating films, α-methylsulfonyl-α,α-dichlorodimethylsulfone is the second worst, while dimethyldisulfide and S-methyl methanethiosulfonate tend to have less adverse effects than these compounds.

Specific permissible contents, calculated as concentrations in the plating bath, are preferably such that the permissible content of dimethyldisulfide is less than 200 ppm, and that of S-methyl methanethiosulfonate is less than 4 ppm. According to the present invention, the content of α-chlorodimethylsulfone and α-methylsulfonyl-α,α-dichlorodimethylsulfone in the plating bath are each less than 4 ppm.

When two or more components among the above sulfur-containing compounds (1) to (4) are present together, it is considered that synergistic effects increase the adverse effects on plating properties. Therefore, when two or more species of sulfur-containing compounds selected from the group consisting of dimethyl disulfide, *S*-methyl methanethiosulfonate, α-chlorodimethylsulfone and α-methylsulfonyl-α,α-dichlorodimethylsulfone are present in the plating bath, the total concentration of these sulfur-containing compounds is preferably less than 2 ppm.

A purified aliphatic sulfonic acid can be produced by removing, from an aliphatic sulfonic acid, compound(s) (A) having a sulfur atom(s) with an oxidation number of +IV or less in the molecule and compound(s) (B) having a sulfur atom(s) and a chlorine atom(s) in the molecule using a method such as concentration under reduced pressure, solid phase extraction or like treatment.

Among such usable methods, reduced pressure concentration is a treatment of concentrating a raw aliphatic sulfonic acid solution by heating under reduced pressure.

Preferable reduced pressure conditions vary depending on the kind of aliphatic sulfonic acid, such as methanesulfonic acid, 2-hydroxyethanesulfonic acid or the like. For example, in the case of methanesulfonic acid, the pressure may be about 0.13 to 6.6 kPa, and preferably about 0.66 to 3.9 kPa.

The heating conditions under reduced pressure also vary somewhat depending on the kind of aliphatic sulfonic acid. For example, in the case of methanesulfonic acid, the temperature may be about 50 to 100°C. The purification may be carried out while gradually increasing the temperature or while maintaining a suitable heating temperature.

The duration of reduced pressure concentration is generally about 1 to 10 hours, and preferably about 3 to 8 hours. The concentration time may be appropriately shortened or extended according to the kind of aliphatic sulfonic acid.

Examples of solutions usable for the raw aliphatic sulfonic acid solution are commercially available aliphatic sulfonic acid solutions, concentrates thereof obtained by appropriate preliminary concentration by heating under atmospheric pressure, and the like.

When the raw aliphatic sulfonic acid solution is treated while heating under reduced pressure, impurities or low boiling point components are efficiently evaporated and removed from the raw solution, and the aliphatic sulfonic acid is concentrated in the non-evaporated residual solution, thus increasing the purity of the aliphatic sulfonic acid.

Solid phase extraction is a treatment of bringing an aliphatic sulfonic acid solution into contact with an adsorbent to remove impurities from the aliphatic sulfonic acid solution.

Examples of usable adsorbents include known adsorbents such as activated carbon, silica gel, activated alumina, activated clays, zeolites, porous polymers and the like. Examples of usable activated carbon are any kinds of carbon having been subjected to carbonization and activation steps. A representative example of a porous polymer is a porous polymer comprising a copolymer of styrene and divinylbenzene as a matrix. Examples of commercially available such products include Amberlite (product of Supelco Inc.).

Such adsorbents are high surface area porous solids having many fine pores in the nanometer size range.

Solid phase extraction may be carried out by a process comprising: preliminarily washing an adsorbent with methanol, ion-exchanged water or the like; packing the adsorbent into a standing column; and adding an aliphatic sulfonic acid solution dropwise to the column at an appropriate flow rate so as to allow the impurities and the like contained in the raw aliphatic sulfonic acid solution to adsorb on the adsorbent, thereby removing the impurities from the aliphatic sulfonic acid solution to give a purified aliphatic sulfonic acid of high purity. The flow rate of the aliphatic sulfonic acid solution in the column may be suitably adjusted according to the kind of aliphatic sulfonic acid, the kind of adsorbent as a stationary phase, the amounts used, etc.

The solid phase extraction treatment can be repeated several times. In this case, the same or different kinds of adsorbents may be used. For example, it is possible to conduct a two-step extraction comprising a first step in which an aliphatic sulfonic acid solution is added dropwise to a column containing an organic adsorbent porous polymer, and a second step in which the aliphatic sulfonic acid solution obtained in the first step is added dropwise to a column containing the same type of porous polymer. Further, if necessary, a multiple-step extraction may be conducted. It is also possible to conduct a 2-step extraction comprising a first step in which an aliphatic sulfonic acid solution is added dropwise to a column containing an inorganic adsorbent such as activated carbon or silica gel, and a second step in which the aliphatic sulfonic acid solution obtained in the first step is added dropwise to a column containing a porous polymer, and, if necessary, further conduct a multiple-step extraction.

The aliphatic sulfonic acid solution may be subjected to a combination of concentration under reduced pressure and solid phase extraction.

For example, after the raw aliphatic sulfonic acid solution is concentrated by heating under reduced pressure, extraction may be conducted by adding the obtained aliphatic sulfonic acid solution dropwise to a column containing an adsorbent, or vice versa. That is, an aliphatic sulfonic acid solution obtained by solid phase extraction may be subjected to concentration under reduced pressure.

Further, it is also possible to combine a reduced pressure concentration treatment and a multiple-step solid phase extraction treatment. In this case, the solid phase extraction treatment as a whole may be carried out before or after the reduced pressure concentration, or the reduced pressure concentration treatment may be interpolated therebetween (i.e., solid phase extraction → reduced pressure concentration → solid phase extraction).

The above-mentioned Japanese Unexamined Patent Publication No. 2001-64249 describes a method of reducing the sulfonic acid content of an alkanesulfonic acid using an anion exchange resin comprising a polymer matrix and a tertiary ammonium salt or like functional group introduced into the matrix. This method is clearly different from the above method using an adsorbent in terms of the target substance to be removed.

The tin-containing plating bath of the invention is a tin plating bath containing as a plating metal component a stannous salt alone or a lead-free tin alloy plating bath containing as a plating metal component a mixture of a soluble stannous salt and at least one soluble salt selected from the group consisting of copper salts, bismuth salts, silver salts, indium salts, zinc salts, nickel salts, cobalt salts and antimony salts.

Among these, tin electroplating baths essentially contain a soluble stannous salt and an aliphatic sulfonic acid as a base acid, and may further contain various additives such as antioxidants, stabilizers, surfactants, brighteners, semibrighteners, pH adjusting agents, and the like, if necessary.

Tin alloy electroplating baths are lead-free plating baths which essentially contain a metal component comprising a soluble stannous salt and at least one soluble salt selected from the group consisting of copper salts, bismuth salts, silver salts, indium salts, zinc salts, nickel salts, cobalt salts and antimony salts, and an aliphatic sulfonic acid as a base acid, and may further contain, if necessary, stabilizers or the like for purposes such as preventing bath decomposition and promoting codeposition of tin and other metal(s) and various additives similar to those used in the tin plating bath.

Of the components added to such a tin or tin alloy electroplating bath, examples of soluble stannous salts include stannous salts of organic sulfonic acids such as methanesulfonic acid, ethanesulfonic acid, 2-propanolsulfonic acid, sulfosuccinic acid, p-phenolsulfonic acid and the like; stannous fluoroborate, stannous sulfate, stannous oxide, stannous chloride, sodium stannate, potassium stannate, and the like.

Examples of salts usable as soluble salts of a specific metal other than lead that forms an alloy with tin are organic salts and inorganic salts that generate metal ions such as Cu⁺, Cu²⁺, Ag⁺, Bi³⁺, In³⁺, Zn²⁺, Ni²⁺, Co²⁺, Co³⁺ and Sb³⁺ in the bath. Such soluble salts can be used singly or mixture of two or more kinds.

Among such soluble salts, examples of soluble copper salts include copper sulfate, copper chloride, copper oxide, copper carbonate, copper acetate, copper pyrophosphate, copper oxalate and the like. Examples of soluble silver salts include silver salts of organic sulfonic acids, such as silver methanesulfonate, silver ethanesulfonate and silver 2-propanolsulfonate; and silver cyanide, silver fluoroborate, silver sulfate, silver sulfite, silver carbonate, silver sulfosuccinate, silver nitrate, silver citrate, silver tartrate, silver gluconate, silver oxalate, silver oxide, silver acetate and the like. Examples of soluble bismuth salts include bismuth sulfate, bismuth oxide, bismuth chloride, bismuth bromide, bismuth nitrate, bismuth salts of organic sulfonic acids, bismuth sulfosuccinate, and the like. Examples of soluble indium salts include indium chloride, indium oxide, indium salts of organic sulfonic acids, and the like. Examples of zinc salts include zinc chloride, zinc sulfate, zinc oxide, zinc salts of organic sulfonic acids, zinc sulfosuccinate, and the like. Examples of usable nickel salts include nickel sulfate, nickel chloride, nickel ammonium sulfate, nickel oxide, nickel acetate, and nickel salts of organic sulfonic acids. Examples of soluble cobalt salts include cobalt sulfate, cobalt chloride, cobalt salts of organic sulfonic acids, and the like. Examples of soluble antimony salts include antimony chloride, antimony fluoroborate, antimony salts of organic sulfonic acids, and the like.

The soluble stannous salt content in the tin electroplating bath is preferably about 1 to 200 g/l, and more preferably about 3 to 100 g/l, calculated as Sn²⁺ ion content.

The soluble stannous salt content in the tin alloy electroplating bath is preferably about 1 to 200 g/l, calculated as Sn²⁺ ion content, and the content of other soluble metal salt(s) is about 0.1 to 100 g/l, calculated as metal component content. It is particularly preferable that the soluble stannous salt content is about 3 to 100 g/l, calculated as Sn²⁺ ion content, and the content of other soluble metal salt(s) is about 0.5 to 50 g/l, calculated as metal component content.

The concentration of at least one aliphatic sulfonic acid selected from the group consisting of alkanesulfonic acids and alkanolsulfonic acids in the tin or tin alloy plating bath is preferably about 1 to 500 g/l, and particularly preferably about 1 to 200 g/l.

The tin or tin alloy plating bath of the invention may be used in any pH range, acidic to neutral or alkaline. Generally, Sn²⁺ in a plating bath is stable in acidic conditions and tends to be unstable in near neutral conditions. Therefore, when the plating bath is used in the near neutral pH range, the use of a complexing agent is effective in stabilizing Sn²⁺ at the neutral range and thereby prevents the formation of white precipitates, bath decomposition, etc.

Examples of usable complexing agents include oxycarboxylic acids, polycarboxylic acids, monocarboxylic acids, salts of such acids, and the like. Specific examples include gluconic acid, citric acid, glucoheptonic acid, gluconolactone, glucoheptlactone, formic acid, acetic acid, propionic acid, butyric acid, ascorbic acid, oxalic acid, malonic acid, succinic acid, glycolic acid, malic acid, tartaric acid, diglycolic acid, salts of such acids, and the like. Among these, gluconic acid, citric acid, glucoheptonic acid, gluconolactone, glucoheptlactone, and salts of these acids are preferable.

Ethylenediamine, ethylenediaminetetraacetic acid (EDTA), diethylenetriaminepentaacetic acid (DTPA), nitrilotriacetic acid (NTA), iminodiacetic acid (IDA), iminodipropionic acid (IDP), hydroxyethylethylenediaminetriacetic acid (HEDTA), triethylenetetraminehexaacetic acid (TTHA), ethylenedioxybis(ethylamine)-N,N,N',N'-tetraacetic acid, glycines, nitrilotrimethyl phosphonic acid, 1-hydroxyethane-1,1-diphosphonic acid, salts of such acids and the like are also effective as complexing agents.

Such complexing agents can be used singly or mixture of two or more kinds.

The concentration of complexing agent in the tin or tin alloy plating bath is not particularly limited but usually preferably about 1 to 20 mol/l.

Antioxidants are used to prevent the oxidation of Sn²⁺ in the bath. Examples of usable antioxidants include hypophosphorous acid and salts thereof, ascorbic acid and salts thereof, hydroquinone, catechol, resorcin, phloroglucinol, cresolsulfonic acid and salts thereof, phenolsulfonic acid and salts thereof, catecholsulfonic acid and salts thereof, hydroquinone sulfonic acid and salts thereof, hydrazine and the like. Such antioxidants can be used singly or as a mixture of two or more kinds.

The concentration of antioxidant in the tin or tin alloy plating bath is not particularly limited but usually preferably about 0.01 to 20 g/l.

Stabilizers may be used particularly for stabilizing the tin alloy plating bath or preventing the tin alloy plating bath from decomposing and for promoting codeposition of tin and other metals. Known stabilizers such as thioureas, thiosulfates, sulfites, thioglycol, thioglycolic acid, thioglycol polyethoxylate, acetylcysteine and like sulfur-containing compounds, cyanides, citric acid and like oxycarboxylic acids are usable. Such stabilizers can be used singly or mixture of two or more kinds.

The concentration of stabilizer in the tin alloy plating bath is not particularly limited but is usually preferably about 0.01 to 100 g/l.

Surfactants contribute to improve the appearance, grain fineness, smoothness, adherence, etc., of the plating film. Examples of usable surfactants include various surfactants such as known nonionic surfactants, anionic surfactants, amphoteric surfactants, cationic surfactants, and the like.

Examples of anionic surfactants include alkylsulfates, polyoxyethylenealkyl ether sulfates, polyoxyethylenealkylphenyl ether sulfates, alkylbenzenesulfonates, alkylnaphthalenesulfonates, and the like. Examples of cationic surfactants include mono/di/tri alkylamine salts, dimethyldialkylammonium salts, trimethylalkylammonium salts, and the like.

Examples of nonionic surfactants include those obtained by addition condensation of about 2 to 300 moles of ethylene oxide (EO) and/or propylene oxide (PO) with a compound such as a C₁-C₂₀ alkanol, phenol, naphthol, bisphenols, C₁-C₂₅ alkylphenol, arylalkylphenol, C₁-C₂₅ alkylnaphthol, C₁-C₂₅ alkoxylated phosphoric acid (salts thereof), sorbitan ester, polyalkylene glycol, C₁-C₂₂ aliphatic amide and the like.

Examples of amphoteric surfactants include carboxybetaine, sulfobetaine, imidazoline betaine, aminocarboxylic acids and the like.

Such surfactants can be used singly or mixture of two or more kinds. The concentration of surfactant in the tin or tin alloy plating bath is not particularly limited, but is usually preferably about 0.01 to 50 g/l.

Examples of useful brighteners and semibrighteners include benzaldehyde, o-chlorobenzaldehyde, 2,4,6-trichlorobenzaldehyde, m-chlorobenzaldehyde, p-nitrobenzaldehyde, p-hydroxybenzaldehyde, furfural, 1-naphthaldehyde, 2-naphthaldehyde, 2-hydroxy-1-naphthaldehyde, 3-acenaphthaldehyde, benzylideneacetone, pyridydeneacetone, furfurylideneacetone, cinnamaldehyde, anisaldehyde, salicylaldehyde, crotonaldehyde, acrolein, glutaraldehyde, paraldehyde, vanillin and like aldehydes; benzothiazole, 2-methylbenzothiazole, 2-aminobenzothiazole, 2-mercaptobenzothiazole and like benzothiazoles; triazine, imidazole, indole, quinoline, 2-vinylpyridine, aniline, phenanthroline, neocuproine, picolinic acid, thioureas, N-(3-hydroxybutylidene)-p-sulfanilic acid, N-butylidenesulfanilic acid, N-cinnamoylidenesulfanilic acid, 2,4-diamino-6-(2'-methylimidazol-1'-yl)ethyl-1,3,5-triazine, 2,4-diamino-6-(2'-ethyl-4-methylimidazol-1'-yl)ethyl-1,3,5-triazine, 2,4-diamino-6-(2'-undecylimidazol-1'-yl)ethyl-1,3,5-triazine, phenyl salicylate, and the like.

Such brighteners and semibrighteners can be used singly or mixture of two or more kinds according to the required state of the plating film. The concentration of brightener and semibrightener in the tin or tin alloy plating bath is not particularly limited, but is usually preferably about 0.01 to 100 g/l.

Examples of usable pH adjusting agents include hydrochloric acid, sulfuric acid and like acids; and aqueous ammonia, potassium hydroxide, sodium hydroxide and like bases. Formic acid, acetic acid, propionic acid and like monocarboxylic acids; boric acids; phosphoric acids; oxalic acid, succinic acid and like dicarboxylic acids; and lactic acid, tartaric acid and like oxycarboxylic acids are also effective.

Examples of conductive salts include sodium salts, potassium salts, magnesium salts, ammonium salts and amine salts of sulfuric acid, hydrochloric acid, phosphoric acid, sulfamic acid, and sulfonic acid. Some of the above pH adjusting agents can be used also as conductive salts. The conductive salt content is usually be about 0 to 100 g/l.

The tin plating bath and tin alloy plating bath of the invention can be used for any plating methods such as barrel plating, rack plating, high-speed continuous plating, rackless plating and the like.

The conditions for electroplating using the tin plating bath and tin alloy plating bath of the invention can be suitably decided. For example, the bath temperature may be about 0°C or higher, and is preferably about 10 to 50°C. The cathode current density may be about 0.001 to 100 A/ dm², and preferably about 0.01 to 30 A/dm².

The tin plating bath and tin alloy plating bath of the invention can also be used for electroless plating. In this case, as with electroplating baths, excellent reflowability and plating appearance can be imparted to the tin plating film or tin alloy plating film, compared to plating baths using conventional aliphatic sulfonic acids. The use of complexing agents such as thioureas in the electroless plating baths is useful for promoting the substitution reaction with a substrate metal such as copper or copper alloy.

As shown above, the tin plating bath and tin alloy plating bath of the invention contain as a base acid a purified aliphatic sulfonic acid with an extremely low content of specific impurities, so that the plating film formed using such a plating bath has excellent reflowability and appearance.

The purified aliphatic sulfonic acid with an extremely low content of specific impurities used in the plating bath of the invention can be obtained by a comparatively easy purification method such as reduced pressure concentration or solid phase extraction, without the need of complicated purification steps as described in Japanese Unexamined Patent Publication No. 204252/1998, and is obtainable using a highly industrially advantageous method.

Compared to using conventional plating baths, when the tin plating bath or tin alloy plating bath of the invention is used to form a bump on a printed circuit board, TAB (Tape Automated Bonding Carrier) or the like, an appropriate mushroom-shaped bump can be formed smoothly instead of a long ridged bump that may impede high-density circuit formation.

The tin plating bath and tin alloy plating bath of the invention are suitably applicable, for example, to semiconductor devices, printed circuit boards, flexible printed circuit boards, film carriers, connectors, switches, resistors, variable resistors, condensers, filters, inductors, thermistors, quartz resonators, lead wires, and like electronic parts when a tin plating film or a tin alloy plating film is formed thereon.

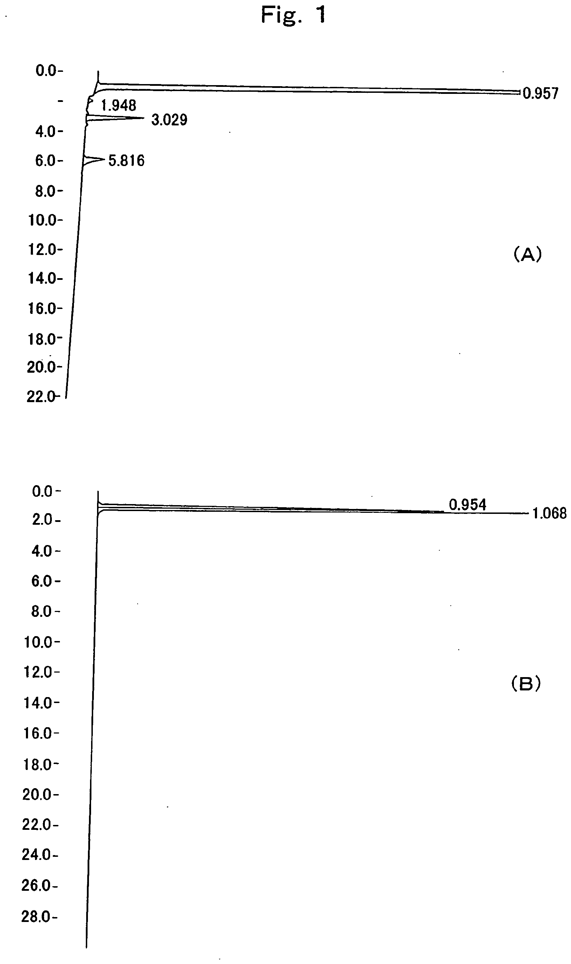

Fig. 1 shows liquid chromatograms of methanesulfonic acid before and after being subjected to the separation/purification treatment of Purification Example 2 below. Fig. 1A is the pre-purification liquid chromatogram. Fig. 1B is the post-purification liquid chromatogram.

Given below are Purification Examples in which an alkanesulfonic acid was purified by reduced pressure concentration and/or solid phase extraction; Examples in which tin plating baths and tin alloy plating baths containing an alkanesulfonic acid having been subjected to such purification treatment(s); and Reflowability Evaluation Test Examples and Appearance Evaluation Test Examples in which the tin plating films and tin alloy plating films obtained using these plating baths were evaluated with respect to reflowability and appearance.

Unpurified alkanesulfonic acids contain minute amounts of various sulfur-containing compounds as impurities. Isolation/identification tests for such sulfur-containing compounds are described. To examine the influence of these sulfur-containing compounds on plating film appearance, the isolated sulfur-containing compounds were added in minute amounts to tin plating baths and tin alloy plating baths containing as a base acid a purified alkanesulfonic acid obtained by reduced pressure concentration, and these results are also described.

### <Purification of alkanesulfonic acid>

Among the following Purification Examples 1 to 8, Purification Example 1 is an example of reduced pressure concentration; Purification Examples 2 and 3 are examples of solid phase extraction using an organic polymer as an adsorbent; Purification Example 4 is an example of solid phase extraction using activated carbon as an adsorbent; Purification Example 5 is an example of 2-step solid phase extraction using an organic polymer as an adsorbent; Purification Example 6 is an example of 2-step solid phase extraction using activated carbon as an adsorbent; and Purification Examples 7 and 8 are examples of 2-step purification using a combination of reduced pressure concentration and solid phase extraction.

### (1) Purification Example 1 using reduced pressure concentration

A commercially available 60% aqueous solution of methanesulfonic acid was placed in a 4-necked flask as a starting solution. A distillation apparatus was assembled using a Liebig condenser, a curved column for fractionation, and an eggplant type flask.

Subsequently, concentration was began at room temperature while reducing the pressure to 5 mmHg using a vacuum pump. The temperature was gradually increased until the liquid temperature reached 100°C to perform the concentration under reduced pressure for about 5 hours, thus producing a 96% methanesulfonic acid.

### (2) Purification Example 2 using solid phase extraction

A 100.0 g quantity of a styrene-divinylbenzene copolymer (Amberlite XAD2; product of Supelco Inc.) was placed in a 500-ml beaker. After 500 ml of methanol (special grade) was added and stirred at room temperature for about 1 hour, the supernatant was discarded. The same procedure was repeated 3 times with methanol. Subsequently, 500 ml of distilled water was placed in the beaker and stirred at room temperature for 10 minutes, followed by discarding the supernatant. The same procedure was repeated 5 times with distilled water. Water was then further removed by filtration under reduced pressure, thus finishing the conditioning process for the adsorbent.

A 10 g quantity of glass wool was packed in an open column with a diameter of 5 cm and a length of 40 cm, and 100 g of the styrene-divinylbenzene copolymer having been subjected to the above conditioning process was then packed, followed by packing 10 g of glass wool thereon.

A 300 g quantity of a commercially available methanesulfonic acid solution (concentration 70%) was added dropwise to this column at a flow rate of 5 ml/min. to give a 70.0% methanesulfonic acid solution.

As mentioned above, Amberlite XAD2 is an adsorbent, and is different from the basic anionic exchange resin used in Japanese Unexamined Patent Publication No. 2001-64249.

### (3) Purification Example 3 using solid phase extraction

A conditioning process and an extraction step were carried out under the same conditions as in Purification Example 2 except that a brominated styrene-divinylbenzene copolymer (Sepabeads SP207; product of Mitsubishi Chemical Corporation) was used as an adsorbent. A 300 g quantity of a commercially available methanesulfonic acid solution (concentration 70%) was added dropwise to the column at a flow rate of 5 ml/min. to give a 70.0% methanesulfonic acid solution.

### (4) Purification Example 4 using solid phase extraction

A 500 g quantity of a commercially available methanesulfonic acid solution (concentration 70.0%) and 50 g of activated carbon (product of Kanto Kagaku Co.) were placed in a 500-ml beaker and stirred for 5 hours, followed by filtration under reduced pressure using a glass fiber filter to collect the filtrate, thus giving a 70.0% methanesulfonic acid solution.

### (5) Purification Example 5 using a 2-step solid phase extraction

A conditioning process and an extraction step were carried out in the same manner as in Purification Example 2 using a styrene-divinylbenzene copolymer (Amberlite XAD2) as an adsorbent. A commercially available methanesulfonic acid solution (concentration 70%) was added dropwise to the column at a flow rate of 5 ml/min. to give a 70.0% methanesulfonic acid solution.

The resulting product was subjected once again to a solid phase extraction using another column containing Amberlite XAD2 having been subjected to the conditioning process to give a 70.0% methanesulfonic acid solution.

### (6) Purification Example 6 using a 2-step solid phase extraction

A conditioning process and an extraction step were carried out in the same manner as in Purification Example 3 using a brominated styrene-divinylbenzene copolymer (Sepabeads SP207) as an adsorbent. A commercially available methanesulfonic acid solution (concentration 70%) was added dropwise to the column at a flow rate of 5 ml/min. to give a 70.0% methanesulfonic acid solution.

A second solid phase extraction was carried out using another column containing activated carbon to give a 70.0% solution of methanesulfonic acid.

### (7) Purification Example 7 using a combination of reduced pressure concentration and solid phase extraction

A 60% aqueous solution of methanesulfonic acid was placed in a 4-necked flask. A distillation apparatus was assembled using a Liebig condenser, a curved column for fractionation, and an eggplant type flask. Concentration was begun at room temperature while reducing the pressure to 5 mmHg using a vacuum pump. The temperature was gradually increased until the liquid temperature reached 100°C to perform the concentration under reduced pressure for about 5 hours, thus giving a 96% methanesulfonic acid solution.

A 10 g quantity of glass wool was packed in an open column with a diameter of 5 cm and a length of 40 cm, and 100 g of a styrene-divinylbenzene copolymer (Amberlite XAD2) having been subjected to the above conditioning process was then packed, followed by packing 10 g of glass wool thereon.

A 300 g quantity of the above methanesulfonic acid solution (concentration 96.0%) obtained by reduced pressure concentration was added dropwise to this column at a flow rate of 5 ml/min. to give a 96.0% methanesulfonic acid solution.

### (8) Purification Example 8 using a combination of reduced pressure concentration and solid phase extraction

A 60% aqueous solution of methanesulfonic acid was placed in 4-necked flask. A distillation apparatus was assembled using a Liebig condenser, a curved column for fractionation, and an eggplant type flask. Concentration was begun at room temperature while reducing the pressure to 5 mmHg using a vacuum pump. The temperature was gradually increased until the liquid temperature reached 100°C to perform the concentration under reduced pressure for about 5 hours, thus producing a 96% methanesulfonic acid solution.

A 10 g quantity of glass wool was packed in an open column with a diameter of 5 cm and a length of 40 cm, and 100 g of a brominated styrene-divinylbenzene copolymer (Sepabeads SP07) having been subjected to the above conditioning process was then packed, followed by packing 10 g of glass wool thereon.

A 300 g quantity of the above 96.0% methanesulfonic acid solution obtained by reduced pressure concentration was added dropwise to this column at a flow rate of 5 ml/min. to give a 96.0% methanesulfonic acid solution.

### <Purification evaluation examples of methanesulfonic acid using liquid chromatography>

Unpurified methanesulfonic acid solution and purified methanesulfonic acid solution were analyzed by high performance liquid chromatography, using Purification Example 2 by solid phase extraction as a representative example.

The high performance chromatographic analysis was carried out using an LC-10AS chromatograph manufactured by Shimadzu Corporation under the following conditions:
Column: ODS-UG-3,
Mobile phase: methanol:water = 1:5, phosphoric acid 2 ml/l
UV detector: 230 nm
Column temperature: 40°C
Flow rate: 1 ml/min.

Fig. 1A is a chromatogram of unpurified methanesulfonic acid solution. Fig. 1B is a chromatogram of purified methanesulfonic acid solution.

The analytical results are as follows:
* Before purification

| PKNO | TIME | AREA | HEIGHT | MK | IDNO | CONC |
|---|---|---|---|---|---|---|
| 1 | 0.957 | 120935 | 11207 | | | 92.5134 |
| 2 | 1.948 | 465 | 40 | | | 0.3557 |
| 4 | 3.029 | 5829 | 553 | V | | 4.4587 |
| 8 | 5.816 | 3493 | 207 | | | 2.6722 |
| | TOTAL | 130722 | 12008 | | | 100 |

* After purification

| PKNO | TIME | AREA | HEIGHT | MK | IDNO | CONC |
|---|---|---|---|---|---|---|
| 2 | 0.954 | 16818 | 3194 | V | | 45.5893 |
| 3 | 1.068 | 20073 | 4880 | SV | | 54.4107 |
| | TOTAL | 36891 | 8073 | | | 100 |

According to these liquid chromatograms, the starting unpurified methanesulfonic acid solution shows absorption peaks at retention times of 3.029 and 5.816 as shown in Fig. 1A, but these two absorption peaks almost disappear in the purified methanesulfonic acid solution obtained in Purification Example 2 as shown in Fig. 1B. The results confirm that impurities were effectively removed from the starting solution and methanesulfonic acid was highly purified by solid extraction. Although the components of the absorption peaks which almost disappeared have not been accurately identified, the components are presumed to be sulfur-containing compounds because the absorption peaks are at positions similar to those where many sulfur-containing compounds show their peaks. However, judging from the positions of the peaks, none of the components is sulfuric acid, i.e., the target component to be removed from alkane sulfonic acid in Japanese Unexamined Patent Publication No. 2001-64249. Thus, since the separation/purification of an aliphatic sulfonic acid according to the invention is different from the purification of an alkane sulfonic acid described in the above publication in the target component to be removed, the purification mechanism is also considered to be different.

When methanesulfonic acid solution was subjected to reduced pressure concentration as in Purification Example 1 instead of solid phase extraction, similar peak disappearance was confirmed by comparing the liquid chromatograms before and after purification. The results show that methanesulfonic acid is effectively highly purified by reduced pressure concentration.

A commercially available 2-hydroxylethane-1-sulfonic acid in place of methanesulfonic acid was subjected to the separation/purification of the invention and the liquid chromatograms before and after purification were analyzed. A similar tendency was observed in the disappearance of absorption peaks.

Subsequently, tin plating baths and tin alloy plating baths containing high-purity methanesulfonic acids obtained in Purification Examples 1 to 8 were prepared as shown below. A blank example using methanesulfonic acid not having been subjected to the separation/purification, and an example using methanesulfonic acid having been subjected to reduced pressure concentration at room temperature without heating are shown as Comparative Examples.

### <Examples of tin plating baths>

### (1) Example 1

Tin plating baths were prepared according to the following formulations:
[Tin plating bath for evaluating reflowability]

| | |
|---|---|
| Stannous chloride (as Sn²⁺) | 50 g/l |
| Methanesulfonic acid of Purification Example 1 | 50 g/l |
| Antioxidant | Small quantity |
| Nonionic surfactant | Small quantity |

[Tin plating bath for evaluating plating film appearance]

| | |
|---|---|
| Stannous chloride (as Sn²⁺) | 80 g/l |
| Methanesulfonic acid of Purification Example 1 | 150 g/l |
| Antioxidant | Small quantity |
| Nonionic surfactant | Small quantity |

In the above plating baths, ascorbic acid, catechol, hydroquinone or the like may be contained as an oxidant in an amount of about 1 to 10 g/l, and an ethylene oxide adduct of a C₁-C₂₀ alkanol, phenol, naphthol, C₁-C₂₅ alkylphenol, C₁-C₂₂ aliphatic amine or the like may be contained as a nonionic surfactant in an amount of about 1 to 10 g/l (the same applied to the Examples and Comparative Examples below).

### (2) Example 2

Tin plating baths were prepared using the same components and contents as in Example 1 except that the methanesulfonic acid obtained in Purification Example 2 was used in place of that obtained in Purification Example 1.

### (3) Example 3

Tin plating baths were prepared using the same components and contents as in Example 1 except that the methanesulfonic acid obtained in Purification Example 3 was used in place of that obtained in Purification Example 1.

### (4) Example 4

Tin plating baths were prepared using the same components and contents as in Example 1 except that the methanesulfonic acid obtained in Purification Example 4 was used in place of that obtained in Purification Example 1.

### (5) Example 5

Tin plating baths were prepared using the same components and contents as in Example 1 except that the methanesulfonic acid obtained in Purification Example 5 was used in place of that obtained in Purification Example 1.

### (6) Example 6

Tin plating baths were prepared using the same components and contents as in Example 1 except that the methanesulfonic acid obtained in Purification Example 6 was used in place of that obtained in Purification Example 1.

### (7) Example 7

Tin plating baths were prepared using the same components and contents as in Example 1 except that the methanesulfonic acid obtained in Purification Example 7 was used in place of that obtained in Purification Example 1.

### (8) Example 8

Tin plating baths were prepared using the same components and contents as in Example 1 except that the methanesulfonic acid obtained in Purification Example 8 was used in place of that obtained in Purification Example 1.

### (9) Example 9

Tin-copper alloy plating baths were prepared according to the following formulations:
[Tin-copper alloy plating bath for evaluating reflowability]

| | |
|---|---|
| Stannous sulfate (as Sn²⁺) | 50 g/l |
| Copper sulfate (as Cu²⁺) | 5 g/l |
| Methanesulfonic acid of Purification Example 7 | 50 g/l |
| Antioxidant | Small quantity |
| Nonionic surfactant | Small quantity |
| Stabilizer | Small quantity |

[Tin-copper alloy plating bath for evaluating plating film appearance]

| | |
|---|---|
| Stannous sulfate (as Sn²⁺) | 80 g/l |
| Copper sulfate (as Cu²⁺) | 8 g/l |
| Methanesulfonic acid of Purification Example 7 | 150 g/l |
| Antioxidant | Small quantity |
| Nonionic surfactant | Small quantity |
| Stabilizer | Small quantity |

The kinds and contents of antioxidants and nonionic surfactants in the above plating baths are the same as described for the tin plating baths. A stabilizer is used for allowing the codeposition of tin and copper to smoothly proceed. Thioureas, nonionic surfactants (e.g., ethylene oxide adducts of laurylamine) and the like can be used instead.

### (10) Example 10

Tin-copper alloy plating baths were prepared using the same components and contents as in Example 9 except that the methanesulfonic acid obtained in Purification Example 8 was used in place of that obtained in Purification Example 7.

### (11) Example 11

Tin-copper alloy plating baths were prepared using the same components and contents as in Example 9 except that the methanesulfonic acid obtained in Purification Example 1 was used in place of that obtained in Purification Example 7.

### (12) Example 12

A tin-bismuth alloy plating bath was prepared according to the following formulation:

| | |
|---|---|
| Stannous sulfate (as Sn²⁺) | 80 g/l |
| Bismuth sulfate (as Bi³⁺) | 8 g/l |
| Methanesulfonic acid of Purification Example 1 | 150 g/l |
| Antioxidant | Small quantity |
| Nonionic surfactant | Small quantity |
| Stabilizer | Small quantity |

The kinds and contents of antioxidant and nonionic surfactant in the above plating bath are the same as described for the tin plating bath. A stabilizer is used for allowing the codeposition of tin and bismuth to smoothly proceed. For example, sulfur-containing compounds such as thioureas are usable.

### (13) Example 13

A tin-silver alloy plating bath was prepared according to the following formulation:

| | |
|---|---|
| Stannous chloride (as Sn²⁺) | 80 g/l |
| Silver nitrate (as Ag⁺(metal silver)) | 8 g/l |
| Methanesulfonic acid of Purification Example 1 | 150 g/l |
| Antioxidant | Small quantity |
| Nonionic surfactant | Small quantity |
| Stabilizer | Small quantity |

The kinds and contents of antioxidant and nonionic surfactant in the above plating bath are the same as described for the tin plating bath. A stabilizer is used for allowing the codeposition of tin and silver to smoothly proceed. For example, sulfur-containing compounds such as thioureas, thioglycol, thioglycolic acid, sulfite, and thiosulfate are usable.

### (14) Example 14

A tin-bismuth alloy plating bath was prepared using the same components and contents as in Example 12 except that the methanesulfonic acid obtained in Purification Example 7 was used in place of that obtained in Purification Example 1.

### (15) Example 15

A tin-bismuth alloy plating bath was prepared using the same components and contents as in Example 12 except that the methanesulfonic acid obtained in Purification Example 8 was used in place of that obtained in Purification Example 1.

### (16) Example 16

A tin-silver alloy plating bath was prepared using the same components and contents as in Example 13 except that the methanesulfonic acid obtained in Purification Example 7 was used in place of that obtained in Purification Example 1.

### (17) Example 17

A tin-silver alloy plating bath was prepared using the same components and contents as in Example 13 except that the methanesulfonic acid obtained in Purification Example 8 was used in place of that obtained in Purification Example 1.

### (18) Comparative Example 1

Tin plating baths were prepared using the same components and contents as in Example 1 except that a commercially available unpurified methanesulfonic acid was used as is in place of that obtained in Purification Example 1.

### (19) Comparative Example 2

Tin plating baths were prepared using the same components and contents as in Example 1 except that a methanesulfonic acid having been subjected to reduced pressure concentration at room temperature without heating was used in place of that obtained in Purification Example 1.

### (20) Comparative Example 3

Tin-copper alloy plating baths were prepared using the same components and contents as in Example 9 except that a commercially available unpurified methanesulfonic acid was used as is in place of that obtained in Purification Example 7.

### (21) Comparative Example 4

A tin-bismuth alloy plating bath was prepared using the same components and contents as in Example 12 except that a commercially available unpurified methanesulfonic acid was used as is in place of that obtained in Purification Example 1.

### (22) Comparative Example 5

A tin-bismuth alloy plating bath was prepared using the same components and contents as in Example 12 except that a methanesulfonic acid having been subjected to reduced pressure concentration at room temperature without heating was used in place of that obtained in Purification Example 1.

### (23) Comparative Example 6

A tin-silver alloy plating bath was prepared using the same components and contents as in Example 13 except that a commercially available unpurified methanesulfonic acid was used as is in place of that obtained in Purification Example 1.

The electrodeposited films obtained using the plating baths of the Examples and Comparative Examples were evaluated with respect to reflowability under more severe conditions than usual by the following methods:

### <Test Example of evaluating the reflowability of tin-containing plating films>

Using the tin plating baths and tin-copper alloy plating baths obtained in Examples 1 to 10 and Comparative Examples 1 to 3, electroplating was performed at a bath temperature of 30°C and a cathode current density of 20 A/dm² to produce a tin plating film or a tin-copper alloy plating film with a film thickness of 5 µm on a Cu substrate.

The test samples coated with plating films were allowed to stand on a hot plate at 300°C for 60 seconds and the plating film appearance was observed with the naked eye to evaluate reflowability of the plating films according to the following criteria:
A: The plating film had a good luster, free of wrinkles and discoloration.
B: The plating film had a slightly opaque luster, but was free of wrinkles.
C: The plating film turned to yellow or blue, but was free of wrinkles.
D: The plating film turned to yellow or blue, and had wrinkles.

Table 1 below shows the above test results.

**Table 1**

| | Examples | | | | | | | | | | Comparative Examples | | |
|---|---|---|---|---|---|---|---|---|---|---|---|---|---|
| | 1 | 2 | 3 | 4 | 5 | 6 | 7 | 8 | 9 | 10 | 1 | 2 | 3 |
| Reflowability | B | B | B | B | B | B | A | A | B | A | C | D | C |

As is clear from the above results, the plating films of Examples 1 to 10 were evaluated as A to B, i.e., excellent results in reflowability, while the plating films of Comparative Examples 1 to 3 were C to D.

Reflowability tests are usually conducted at 260°C or slightly higher for about 10 seconds. In this test, more severe conditions than such conditions, i.e., conditions under which discoloration and wrinkles easily occur on plating films were used. Therefore, discoloration and wrinkles seem to have occurred on the plating films in Comparative Examples 1 and 2 using a conventional methanesulfonic acid not having been subjected to the separation/purification of the invention. In contrast, in Examples 1 to 10, the plating films had no wrinkles and generally had good luster, despite of these severe conditions.

A comparison of Examples 1 to 6 with Comparative Example 1 confirms that when an alkanesulfonic acid having been subjected to the separation/purification of the invention is used in tin plating baths, reflowability is greatly improved compared to no such a separation/purification. A comparison of Examples 9 to 10 with Comparative Example 2 confirms that the separation/purification of the invention contributes to the improvement of reflowability also in tin alloy plating baths. Further, a comparison of Example 1 with Comparative Example 2 confirms that when an alkanesulfonic acid is concentrated under reduced pressure, it is important to concentrate while heating, in terms of enhancement of reflowability. A comparison of Examples 1 to 6 with Examples 7 and 8 reveals that reflowability is more effectively improved by combining reduced pressure concentration and solid phase separation, compared to performing only one of these treatments.

As shown above, the results reveal that tin plating baths and tin alloy plating baths containing an alkanesulfonic acid having been subjected to the separation/purification of the invention as a base acid are clearly superior to those containing an alkanesulfonic acid not having been subjected to the separation/purification, in terms of improvement of reflowability of the obtained plating film. Therefore, when the tin plating film or tin alloy plating film obtained using the plating bath of the invention is used in electronic parts or the like, reliability of the plating film can be remarkably enhanced, compared to conventional means.

Subsequently, by using a cathode current density higher than usual, plating was performed under conditions where burning and nonuniformity of the plating film may easily occur. The electrodeposited films obtained using the plating baths of the Examples and Comparative Examples were evaluated with respect to appearance.

### 〈〈Test Example of evaluating the appearance of tin-containing plating films〉〉

Using the tin plating baths and tin alloy plating baths obtained in Examples 1 to 17 and Comparative Examples 1 and 3 to 6, electroplating was carried out under the conditions shown below to form a tin plating film or a tin alloy plating film with a film thickness of 10 µm on a copper leadframe. The state of the plating film on the lead ends was observed with a magnifying glass and the generation of nonuniformity of the plating film over the entire leadframe was observed with the naked eye to evaluate the quality of the plating film appearance.

### [Plating conditions]

| | Sn bath | Sn-Cu bath | Sn-Bi bath | Sn-Ag bath |
|---|---|---|---|---|
| Bath temperature (°C) | 30 | 30 | 30 | 30 |
| Current density (A/dm²) | 40 | 30 | 40 | 30 |

The plating film appearance was evaluated according to the following criteria:
A: Burning and nonuniformity were not observed on the plating film.
B: Slight burning was observed on the lead ends but nonuniformity was not observed.
C: Burning was observed on the lead ends but nonuniformity was not observed.
D: Burning and nonuniformity were observed over almost the entire lead surface.

Table 2 below shows the test results.

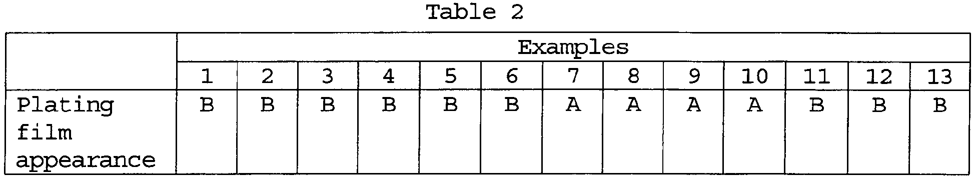

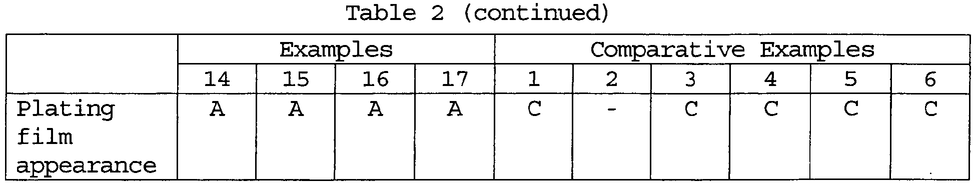

The plating films of Examples 1 to 17 were evaluated as A to B, i.e., excellent results in film appearance, while the plating films of Comparative Examples 1 and 3 to 6 were C.

Electroplating is usually performed at a cathode current density of about 10 to 20 A/dm². In this test, more severe conditions under which burning and nonuniformity of the plating film easily occur were used by increasing the cathode current density to a density of 40 to 50 A/dm². Therefore, burning seems to have occurred in Comparative Examples 1 and 3 to 6 using a conventional methanesulfonic acid not having been subjected to the separation/purification of the invention. In contrast, in Examples 1 to 17, nonuniformity of the plating film was not observed and generally no burning was observed, despite of the severe conditions.

A comparison of Examples 1 and 2 to 7 with Comparative Example 1 confirms that when an alkanesulfonic acid having been subjected to the separation/purification of the invention is used in tin plating baths, film appearance is greatly improved compared to no separation/purification. A comparison of Examples 10 to 11 with Comparative Example 3 confirms that the alkanesulfonic acid having been subjected to the separation/purification of the invention contributes also to the improvement of film appearance using tin-copper alloy plating baths. It is also clear that the alkanesulfonic acid having been subjected to the separation/purification of the invention contributes to the improvement of plating film appearance using tin-bismuth alloy plating baths (a comparison of Examples 12 and 15 with Comparative Example 4), and tin-silver alloy plating baths (a comparison of Examples 13 and 17 with Comparative Example 6). Further a comparison of Example 12 and Comparative Example 5 confirms that when an alkanesulfonic acid solution is concentrated under reduced pressure, it is important to concentrate while heating, to enhance film appearance. A comparison of Examples 1, 2 to 6 and 11 to 13 with Examples 7 to 10 and 14 to 17 reveals that film appearance is more effectively improved by combining reduced pressure concentration and solid phase separation, compared to performing only one of these treatments.

Thus the results reveal that tin plating baths and tin alloy plating baths containing an alkanesulfonic acid having been subjected to the separation/purification of the invention as a base acid are clearly superior to plating baths containing an alkanesulfonic acid not having been subjected to the separation/purification, in terms of improvement of the obtained plating film appearance. Therefore, it is clear that when the tin plating film or tin alloy plating film obtained using the plating bath of the invention is used in electronic parts or the like, reliability of the plating film can be remarkably enhanced, compared to conventional means.

In summary, it became clear that when electroplating is performed using a tin or tin alloy plating bath containing, as a base acid, a purified methanesulfonic acid obtained by subjecting a commercially available methanesulfonic acid solution to reduced pressure concentration and/or solid phase concentration, plating films can be improved in terms of appearance, reflowability, etc.

Excellent plating properties are obtained by subjecting methanesulfonic acid to such a specific separation/purification treatment. This strongly suggests that impurities that adversely affect plating properties are eliminated from the methanesulfonic acid by the separation/purification.

Accordingly, work to identify the sulfur-containing compounds eliminated from the methanesulfonic acid by the above separation/purification, and work to confirm which components adversely affect plating properties and which components do not have such adverse effects among these sulfur-containing compounds was carried out, based on the tests shown below.

### 〈〈Test Example of isolating and identifying impurities in methanesulfonic acid〉〉

A 100 ml quantity of a commercially available methanesulfonic acid solution was extracted with 300 ml of dichloromethane and the dichloromethane was then removed from the extract using an evaporator. Subsequently, extraction and solvent removal were repeated several times to give a water-containing mixture of impurities. To remove water from the impurities, 30 ml of dichloromethane was added and 5 g of sodium sulfate was added. The supernatant was decantated and the solvent was removed using an evaporator to give a mixture of impurities.

A 3 ml quantity of methanol was added to the obtained mixture of impurities and the resulting mixture was subjected to high performance liquid chromatography using recycling preparative high performance liquid chromatography (product of Japan Analytical Industry Co., Ltd.; model LC-908) under the conditions shown below to obtain isolates.
Column: Shodex Asahipak GS-310 21G
Mobile phase: Methanol
Flow rate: 3.8 ml/min.
Detector: RI

The isolates were identified using various analytical instruments, such as ¹³C-NMR, ¹H-NMR, IR, GC-MS, MS, and elemental analysis.

As a result, the sulfur-containing compounds (1) to (5) shown below were identified based on the various analytical data.

In the analytical data shown below, "s" for ¹H-NMR means a singlet peak, while for IR, "w" stands for a weak peak, "m" a moderate peak, and "s" a strong peak.
(1) Dimethyldisulfide
   P&T-GC/MS:ms 94,79,61,45
(2) S-methyl methanethiosulfonate
   ¹H-NMR (ppm) : 2.709 (s, 3H, -SO₂CH₃), 3.315 (s, 3H, -SCH₃)
   IR (cm⁻¹) : 1134.1 (s, R-SO₂-R), 1305.7 (m, R-SO₂-R), 1330.8 (m, -S- CH₃), 1410.0 (w, -S-CH₃)
(3) α-chlorodimethylsulfone
   ¹H-NMR (ppm) : 3.054 (s, 3H, -SO₂CH₃), 4.447 (s, 2H, -CH₂Cl)
   IR (cm⁻¹) : 761.8 (s, -CH₂-Cl), 1120.6 (s, R-SO₂-R), 1245.9 (m, -CH₂-Cl), 1313.4 (s, R-SO₂-R)
   GC/MS:ms 128, 113, 93, 79, 63, 49
   Elemental analysis (C,H) : (C₂H₅SO₂Cl) C:18.89%, H:3.48%
(4) α-methylsulfonyl-α,α-dichlorodimethylsulfone
   ¹H-NMR (ppm) : 2.920 (s, 3H, -SO₂CH₃), 3.369 (s, 3H, -SOCH₃),
   ¹³C-NMR (ppm): 36.873, 39.832, 105.880
   IR (cm⁻¹) : 1083.9 (s, -SOCH₃), 1147.6 (s, R-SO₂-R) , 1321.1 (s, R-SO₂-R), 1332.7 (m, -SOCH₃)
   Elemental analysis (C,H,N,S,O):
      (C₃H₆S₂O₃Cl₂) C:16.20%, H:2.56%, S:29.86%, O:21.54%
(5) Dimethylsulfone
   ¹H-NMR (ppm): 2.991 (s, 3H, -SO₂CH₃)
   IR (cm⁻¹) : 1136.0 (s, R-SO₂-R), 1298.0 (s, R-SO₂-R)

By extracting impurities from 1 liter of a commercially available 70% methanesulfonic acid solution with dichloromethane, the concentrations of the impurities in the unpurified methanesulfonic acid were calculated. The results and presumptions are shown below. The concentration of S-methyl methanethiosulfonate (2) was 1.6 ppm, and the concentration of dimethylsulfone (5) was 2.5 ppm. In the light of the concentration of dimethylsulfone (5), the concentration of α-chlorodimethylsulfone (3) and the concentration of α-methylsulfonyl-a,a-dichlorodimethylsulfone (4) are presumed to be 1.2 ppm and 2.5 ppm, respectively. The concentration of dimethyldisulfide (1) seems to be similar to that of dimethylsulfone (5).

Accordingly, 5 types of sulfur-containing compounds isolated and identified in the above test were independently added in minute amounts to the purified methanesulfonic acid obtained by reduced pressure concentration in Purification Example 1 to prepare tin plating baths and tin alloy plating baths containing such sulfur-containing compound as an impurity. The electrodeposited films obtained using these plating baths were evaluated with respect to appearance to assess whether each sulfur-containing compound is a component that adversely affects plating properties or a component that does not have such adverse effects.

### 〈〈Test Example of assessing the influence of sulfur-containing compounds on plating properties〉〉

A tin plating bath, a tin-bismuth alloy plating bath, and a tin-silver alloy plating bath are each described below.

### (1) Tin plating bath

A tin plating bath of the following formulation was prepared.

| | |
|---|---|
| Stannous chloride (as Sn²⁺) | 60 g/l |
| Methanesulfonic acid of Purification Example 1 | 106 g/l |
| Nonionic surfactant | 10 g/l |
| Anionic surfactant | Small quantity |
| Antioxidant | Small quantity |

In the above plating bath, bisphenol polyethoxylate was used as a nonionic surfactant. About 2 g/l of sodium dibutylnaphthalene sulfonate was used as an anionic surfactant, and about 1 g/l of ascorbic acid was used as an antioxidant.

Subsequently, one of the sulfur-containing compounds (1) to (5) isolated in the above test was independently added and similarly a mixture of sulfur-containing compounds (3) and (4) in a weight ratio of 1:1 was added to such a tin plating bath. The concentrations of the sulfur-containing compounds added to the plating baths were varied from 0 to 5 ppm (increasing by 1 ppm each time), and 10 ppm, 50 ppm, 100 ppm to 200 ppm.

Using the tin plating baths containing such varied concentrations of the sulfur-containing compounds, tin plating films were formed to a thickness of 10 µm on a Cu leadframe at a bath temperature of 40°C, a cathode current density of 20 A/dm², and a cathode rocking rate of 6 m/min. The obtained plating films were evaluated in a manner similar to the Test Example of evaluating the plating film appearance. That is, the state of deposited plating on the lead ends was observed with a magnifying glass and the generation of nonuniformity of the plating film over the entire leadframe was observed with the naked eye to evaluate the quality of the plating film appearance.

The film appearance was evaluated according to the following criteria:
A: At least 60% of the total surface area of the plating film had a good appearance.
B: Between 40% and 60% of the total surface area of the plating film had a good appearance.
C: Less than 40% of the total surface area of the plating film had a good appearance.

The tables below show the test results. Compound (1) is dimethyldisulfide, compound (2) is S-methyl methanethiosulfonate, compound (3) is α-chlorodimethylsulfone, compound (4) is α-methylsulfonyl-α,α-dichlorodimethylsulfone, and compound (5) is dimethylsulfone.

| | (5) | (1) | (2) | (3) | (4) | (3) + (4) |
|---|---|---|---|---|---|---|
| 0 ppm | A | A | A | A | A | A |
| 1 ppm | A | A | A | A | A | B |
| 2 ppm | A | A | B | B | B | C |
| 3 ppm | A | A | B | B | B | C |
| 4 ppm | A | A | C | C | C | C |
| 5 ppm | A | A | C | C | C | C |
| 10 ppm | A | A | C | C | C | C |
| 50 ppm | A | A | C | C | C | C |
| 100 ppm | A | B | C | C | C | C |
| 200 ppm | A | C | C | C | C | C |

The above results show that dimethylsulfone (5) does not impair the plating film appearance and does not affect plating properties, even when contained at a concentration of 200 ppm.

In contrast, dimethyldisulfide (1) at a concentration of 200 ppm was evaluated as C in film appearance and the same compound at a concentration of 100 ppm (i.e., at a concentration of 100 ppm or more but less than 200 ppm) was evaluated as B. Thus a comparison with dimethylsulfone (5) clearly confirms that dimethyldisulfide (1) adversely affects plating properties.

*S*-methyl methanethiosulfonate (2), α-chlorodimethylsulfone (3) and α-methylsulfonyl-α,α-dichlorodimethylsulfone (4), each at a concentration of 4 ppm, were evaluated as C in appearance and the same compounds at a concentration of 3 ppm (i.e., at a concentration of 3 ppm or more but less than 4 ppm) were evaluated as B. The results confirm that compounds (2) to (4), as with dimetyldisulfide (1), adversely affect plating properties. Further, the results reveal that the permissible concentrations of compounds (2) to (4) in the plating bath are lower than that of dimethyldisulfide (1), and compounds (2) to (4) adversely affect plating properties, even when present in an amount only slightly more than a minute amount in the bath.

Focusing on the case of coexistance of sulfur-containing compounds, for example, compound (3) and (4), when present singly at a concentration of 2 ppm, these were evaluated as B in appearance, but these compounds, when present together, were evaluated as C at a total concentration of 2 ppm. Compounds (3) and (4), when present together at a total concentration of 1 ppm (i.e., at a concentration of 1 ppm or more but less than 2 ppm), were evaluated as B. These results confirm that compounds (3) and (4) when present together are poorer in terms of appearance, compared to the case when only one of the compounds is present at the same concentration. Thus the results reveal that when a plurality of sulfur-containing compounds are present together, a synergistic effect accelerates the degradation of plating properties.

As shown above, the results confirm that in a tin plating bath containing methanesulfonic acid as a base acid, not all the sulfur-containing compounds that are present as impurities in methanesulfonic acid adversely affect plating properties; compounds such as dimethylsulfone (5) do not adversely affect plating properties, and only specific compounds adversely affect plating properties. As described above, the compounds that adversely affect plating properties are compounds (1) to (4), which are, importantly, found to be compounds having a sulfur atom(s) with an oxidation number of +4 or less in the molecule or compounds having a sulfur atom(s) and a chlorine atom(s) in the molecule.

Moreover, the degree of influence on plating properties (i.e., permissible concentration in the plating bath) varies among compounds (1) to (4). When each sulfur-containing compound is present singly in the bath, the permissible concentration of compound (1) is presumed to be less than 200 ppm, and those of compounds (3) and (4) less than 4 ppm. Further, the results confirm that when, instead of a single component, two or more components are present together in the bath, a synergistic effect tends to accelerate the degradation of plating properties. When two or more of compounds (1) to (4) are present together in the bath, the total permissible concentration is presumed to be less than 2 ppm.

### (2) Tin-bismuth alloy plating bath

A tin-bismuth alloy plating bath of the following formulation was prepared.

| | |
|---|---|
| Stannous sulfate (as Sn²⁺) | 80 g/l |
| Bismuth sulfate (as Bi³⁺) | 8 g/l |
| Methanesulfonic acid of Purification Example 1 | 150 g/l |
| Nonionic surfactant | Small quantity |
| Antioxidant | Small quantity |

In the above plating bath, about 5 g/l of nonylphenol polyethoxylate was used as a nonionic surfactant, and about 1 g/l of ascorbic acid was used as an antioxidant.

Subsequently, the sulfur-containing compounds (1) to (5) isolated in the above test were added to such tin-bismuth alloy plating baths under the same conditions as for the above-mentioned tin plating bath, and the appearance of the electrodeposited films were evaluated. More specifically, sulfur-containing compounds (1) to (5) were added at varying concentrations from 0 ppm to 200 ppm to the plating bath singly or in combination, and tin-bismuth alloy plating films were formed on a Cu leadframe under the same electroplating conditions as for the tin plating bath to evaluate the appearance of the electrodeposited films. The evaluation criteria were the same as for the tin plating bath.

The table below shows the test results.

| | (5) | (1) | (2) | (3) | (4) | (3) + (4) |
|---|---|---|---|---|---|---|
| 0 ppm | A | A | A | A | A | A |
| 5 ppm | A | A | A | A | A | B |
| 10 ppm | A | A | A | A | B | C |
| 50 ppm | A | A | B | B | C | C |
| 100 ppm | A | A | C | C | C | C |
| 200 ppm | A | B | C | C | C | C |

The above results show that dimethylsulfone (5) does not impair the plating film appearance and does not affect plating properties, even when contained at a concentration of 200 ppm.

In contrast, compounds (1) to (4) impair the appearance of plating films, thus being confirmed to adversely affect plating properties. The influence on plating properties varies according to the kind of compound. Similarly to the tendency observed for the tin plating bath, the results reveal that compound (1) has a small degree of influence, compound (4) has a large degree of influence, while compounds (2) and (3) fall between compounds (1) and (4).

As shown above, the results reveal an important point: also in a tin-bismuth alloy plating bath containing methanesulfonic acid as a base acid, not all the sulfur-containing compounds that are present as impurities in the methanesulfonic acid adversely affect plating properties; compounds such as dimethylsulfone (5) do not adversely affect plating properties, while compounds having a sulfur atom(s) with an oxidation number of +4 or less in the molecule and compounds having a sulfur atom(s) and a chlorine atom(s) in the molecule adversely affect plating properties.

As with the case of the tin plating bath, the results reveal that when not a single but two or more components among compounds (1) to (4) are present together in the tin alloy plating bath, a synergistic effect tends to accelerate the degradation of plating properties.

Further, the results confirm that in a tin-bismuth alloy plating bath, the permissible concentrations of compounds (1) to (4), i.e., compounds that adversely affect plating properties, are higher than those in the tin plating bath. Compound (1) was evaluated as C in appearance at a concentration of 200 ppm in the tin plating bath but was evaluated as B at the same concentration in the tin-bismuth alloy plating bath, so that there is a possibility that it may be evaluated as B even at a concentration higher than 200 ppm. Compound (4) was evaluated as C in appearance at a concentration of 10 ppm in the tin plating bath but was evaluated as B at the same concentration in the tin-bismuth alloy plating bath, so that there is a possibility that it may be evaluated as B even at a concentration higher than 10 ppm. Thus it was confirmed that the permissible concentrations of these compounds in the tin-bismuth alloy plating bath are higher than in the tin plating bath.

Therefore, it seems that when these specific sulfur-containing compounds are present as impurities in a bath, tin-bismuth alloy plating baths have higher resistance to degradation of plating properties than tin plating baths, so that even when a tin-bismuth alloy plating bath has a higher concentration of impurities than a tin plating bath, adverse effects on plating properties less readily occur.

### (3) Tin-silver alloy plating bath

A tin-silver alloy plating bath of the following formulation was prepared.

| | |
|---|---|
| Stannous sulfate (as Sn²⁺) | 80 g/l |
| Silver nitrate (as Ag⁺) | 8 g/l |
| Methanesulfonic acid of Purification Example 1 | 150 g/l |
| Stabilizer | 40 g/l |
| Nonionic surfactant | Small quantity |
| Antioxidant | Small quantity |

The kinds and amounts of nonionic surfactant and antioxidant used in the above tin-silver alloy plating bath were the same as in the tin-bismuth alloy plating bath. Thioglycol polyethoxylate was used as a stabilizer.

Sulfur-containing compounds (1) to (5) isolated in the above test were added to such tin-silver alloy baths under the same conditions as for the tin plating bath, and the appearance of the electrodeposited films were evaluated. More specifically, sulfur-containing compounds (1) to (5) were added at varying concentrations from 0 ppm to 200 ppm to the plating bath singly or in combination, and tin-silver alloy plating films were formed on a Cu leadframe under the same electroplating conditions as for the tin plating bath to evaluate the appearance of the electrodeposited films. The evaluation criteria were the same as for the tin plating bath.

The table below shows the test results.

| | (5) | (1) | (2) | (3) | (4) | (3) + (4) |
|---|---|---|---|---|---|---|
| 0 ppm | A | A | A | A | A | A |
| 5 ppm | A | A | A | A | A | C |
| 10 ppm | A | A | B | B | B | C |
| 50 ppm | A | A | C | C | C | C |
| 100 ppm | A | A | C | C | C | C |
| 200 ppm | A | B | C | C | C | C |

The results show that dimethylsulfone (5) does not impair the plating film appearance and does not affect plating properties, even when contained at a concentration of 200 ppm.

In contrast, compounds (1) to (4) impair the appearance of plating films, thus being confirmed to adversely affect plating properties. The influence on plating properties varies according to the kind of compound. Similarly to the tendency observed for the tin plating bath, the results reveal that compound (1) has a small degree of influence, while compounds (2) to (4) have more influence than compound (1).

As shown above, the results reveal an important point: also in a tin-silver alloy plating bath containing methanesulfonic acid as a base acid, not all the sulfur-containing compounds that are present as impurities in methanesulfonic acid adversely affect plating properties; compounds such as dimethylsulfone (5) do not adversely affect plating properties, and only the compounds having a sulfur atom(s) with an oxidation number of +4 or less in the molecule and compounds having a sulfur atom(s) and a chlorine atom(s) in the molecule adversely affect plating properties.

As with the case of the tin plating bath, the results reveal that when not a single but two or more components among compounds (1) to (4) are present together in the tin-silver alloy plating bath, a synergistic effect tends to accelerate the degradation of plating properties.

The results confirm that in the tin-silver alloy plating bath, the permissible concentrations of compounds (1) to (4) that adversely affect plating properties are higher than those in the tin plating bath but lower than those in the tin-bismuth alloy plating bath. Compound (1) was evaluated as B in appearance at a concentration of 200 ppm in the tin-silver alloy plating bath, but was evaluated as C in the tin plating bath. Compound (4) was evaluated as B in appearance at a concentration of 10 ppm in the tin-silver alloy plating bath, but was evaluated as C in the tin plating bath. Thus the permissible concentrations of these compounds in the tin-silver alloy plating bath are higher than in the tin plating bath. Compounds (2) and (3) were evaluated as B in appearance at a concentration of 10 ppm in the tin-silver alloy plating bath, but were evaluated as A in the tin-bismuth alloy plating bath. Thus it was observed that the permissible concentrations of these compounds in the tin-bismuth alloy plating bath are higher than in the tin-silver alloy plating bath.

The above results confirm that when these specific sulfur-containing compounds are present as impurities, the tin-silver alloy plating bath tends to have higher resistance to the degradation of plating properties than the tin plating bath but have lower resistance than the tin-bismuth alloy plating bath. Therefore, it seems that even when a tin-silver alloy plating bath has a higher concentration of impurities, adverse effects on plating properties less readily occur, compared to a tin plating bath, but are prone to occur than in a tin-bismuth alloy plating bath.

## Claims

1. A tin-containing plating bath comprising:
(a) a soluble stannous salt, or
a mixture of a soluble stannous salt and at least one soluble salt selected from the group consisting of copper salts, bismuth salts, silver salts, indium salts, zinc salts, nickel salts, cobalt salts, and antimony salts; and
(b) at least one purified aliphatic sulfonic acid selected from the group consisting of alkanesulfonic acids and alkanolsulfonic acids,
wherein the purified aliphatic sulfonic acid is one obtained by purifying an aliphatic sulfonic acid that has been produced by hydrolyzing an alkylsulfonyl halide,
the content of α-chlorodimethylsulfone in the plating bath is less than 4 ppm, and
the content of α-methylsulfonyl-α,α-dichlorodimethylsulfone in the plating bath is less than 4 ppm.

2. The tin-containing plating bath according to claim 1 wherein
at least two sulfur-containing compounds selected from the group consisting of dimethyldisulfide, S-methyl methanethiosulfonate, α-chlorodimethylsulfone and α-methylsulfonyl-α,α-dichlorodimethylsulfone are present in the plating bath; and
the total content of the sulfur-containing compounds in the plating bath is less than 2 ppm.

3. The tin-containing plating bath according to claim 1 wherein the purified aliphatic sulfonic acid is one obtained by subjecting an aliphatic sulfonic acid to concentration under reduced pressure while heating.

4. The tin-containing plating bath according to claim 1 wherein the purified aliphatic sulfonic acid is one obtained by subjecting an aliphatic sulfonic acid to solid phase extraction in which the aliphatic sulfonic acid is brought into contact with an adsorbent.

5. The tin-containing plating bath according to claim 4 wherein the purified aliphatic sulfonic acid is one obtained by subjecting an aliphatic sulfonic acid to solid phase extraction at least twice, using the same or different kinds of adsorbents.

6. The tin-containing plating bath according to claim 1 wherein the purified aliphatic sulfonic acid is one obtained by subjecting an aliphatic sulfonic acid to a combination of concentration under reduced pressure and solid phase extraction.

7. The tin-containing plating bath according to claim 1 wherein the alkanesulfonic acid is methanesulfonic acid.

## Patentansprüche

1. Zinnhaltiges Plattierungsbad, umfassend:
(a) ein lösliches Zinnsalz oder
ein Gemisch eines löslichen Zinnsalzes und mindestens einem löslichen Salz, ausgewählt aus der Gruppe, bestehend aus Kupfersalzen, Bismutsalzen, Silbersalzen, Indiumsalzen, Zinksalzen, Nickelsalzen, Cobaltsalzen und Antimonsalzen; und
(b) mindestens eine gereinigte aliphatische Sulfonsäure, ausgewählt aus der Gruppe, bestehend aus Alkansulfonsäuren und Alkanolsulfonsäuren,
wobei die gereinigte aliphatische Sulfonsäure eine ist, die durch Reinigen einer aliphatischen Sulfonsäure, welche durch Hydrolysieren eines Alkylsulfonylhalogenids hergestellt wurde, erhalten ist,
der Gehalt an α-Chlordimetyhlsulfon in dem Plattierungsbad weniger als 4 ppm beträgt und
der Gehalt an α-Methylsulfonyl-α,α-dichlordimethylsulfon in dem Plattierungsbad weniger als 4 ppm beträgt.

2. Zinnhaltiges Plattierungsbad nach Anspruch 1, wobei mindestens zwei schwefelhaltige Verbindungen, ausgewählt aus der Gruppe, bestehend aus Dimethyldisulfid, S-Methylmethanthiosulfonat, α-Chlordimethylsulfon und α-Methylsulfonyl-α,α-dichlordimethylsulfon, in dem Plattierungsbad vorhanden sind; und
der Gesamtgehalt an den schwefelhaltigen Verbindungen in dem Plattierungsbad weniger als 2 ppm beträgt.

3. Zinnhaltiges Plattierungsbad nach Anspruch 1, wobei die gereinigte aliphatische Sulfonsäure eine ist, die durch Unterwerfen einer aliphatischen Sulfonsäure einer Konzentrierung unter reduziertem Druck während Erwärmung erhalten ist.

4. Zinnhaltiges Plattierungsbad nach Anspruch 1, wobei die gereinigte aliphatische Sulfonsäure eine ist, die durch Unterwerfen einer aliphatischen Sulfonsäure einer Festphasenextraktion, in welcher die aliphatische Sulfonsäure mit einem Adsorbtionsmittel in Kontakt gebracht wird, erhalten ist.

5. Zinnhaltiges Plattierungsbad nach Anspruch 4, wobei die gereinigte aliphatische Sulfonsäure eine ist, die durch mindestens zweimaliges Unterwerfen einer aliphatischen Sulfonsäure einer Festphasenextraktion erhalten ist, unter Verwendung des gleichen oder unterschiedlichen Arten von Adsorbtionsmittel.

6. Zinnhaltiges Plattierungsbad nach Anspruch 1, wobei die gereinigte aliphatische Sulfonsäure eine ist, die durch Unterwerfen einer aliphatischen Sulfonsäure einer Kombination aus Konzentrierung unter reduziertem Druck und Festphasenextraktion erhalten ist.

7. Zinnhaltiges Plattierungsbad nach Anspruch 1, wobei die Alkansulfonsäure Methansulfonsäure ist.

## Revendications

1. Bain galvanoplastique contenant de l'étain comprenant :
(a) un sel stanneux soluble, ou
un mélange d'un sel stanneux soluble et d'au moins un sel soluble sélectionné dans le groupe consistant en les sels de cuivre, les sels de bismuth, les sels d'argent, les sels d'indium, les sels de zinc, les sels de nickel, les sels de cobalt et les sels d'antimoine ; et
(b) au moins un acide sulfonique aliphatique purifié sélectionné dans le groupe consistant en les acides alcanesulfoniques et les acides alcanolsulfoniques,
dans lequel l'acide sulfonique aliphatique purifié est un acide obtenu en purifiant un acide sulfonique aliphatique qui a été produit par hydrolyse d'un halogénure d'alkylsulfonyle,
la teneur d'α-chlorodiméthylsulfone dans le bain galvanoplastique est inférieure à 4 ppm, et
la teneur d'α-méthylsulfonyl-α,α-dichlorodiméthylsulfone dans le bain galvanoplastique est inférieure à 4 ppm.

2. Bain galvanoplastique contenant de l'étain selon la revendication 1, dans lequel
au moins deux composés contenant du soufre sélectionnés dans le groupe consistant en le diméthyldisulfure, le méthanethiosulfonate de S-méthyle, l'α-chlorodiméthylsulfone et l'α-méthylsulfonyl-α,α-dichlorodiméthylsulfone sont présents dans le bain galvanoplastique ; et
la teneur totale des composés contenant du soufre dans le bain galvanoplastique est inférieure à 2 ppm.

3. Bain galvanoplastique contenant de l'étain selon la revendication 1, dans lequel
l'acide sulfonique aliphatique purifié est un acide obtenu en soumettant un acide sulfonique aliphatique à une concentration sous pression réduite tout en chauffant.

4. Bain galvanoplastique contenant de l'étain selon la revendication 1, dans lequel
l'acide sulfonique aliphatique purifié est un acide obtenu en soumettant un acide sulfonique aliphatique à une extraction en phase solide dans laquelle l'acide sulfonique aliphatique est amené en contact avec un adsorbant.

5. Bain galvanoplastique contenant de l'étain selon la revendication 4, dans lequel
l'acide sulfonique aliphatique purifié est un acide obtenu en soumettant un acide sulfonique aliphatique à une extraction en phase solide au moins deux fois, en utilisant les mêmes types ou des types différents d'adsorbants.

6. Bain galvanoplastique contenant de l'étain selon la revendication 1, dans lequel
l'acide sulfonique aliphatique purifié est un acide obtenu en soumettant un acide sulfonique aliphatique à une combinaison d'une concentration sous pression réduite et d'une extraction en phase solide.

7. Bain galvanoplastique contenant de l'étain selon la revendication 1, dans lequel
l'acide alcanesulfonique est l'acide méthanesulfonique.
